# EUROPEAN PATENT APPLICATION

(11) **EP 4 542 624 A1**
(43) Date of publication of application: **23.04.2025**
(21) Application number: 24183663.4
(22) Date of filing: 21.06.2024
(51) Int. Cl.: H01L 21/28, H10B 12/00

(54) **SEMICONDUCTOR DEVICE**

(30) Priority: 20.10.2023 KR 20230141262
(71) Applicant: Samsung Electronics Co., Ltd., Suwon-si, Gyeonggi-do 16677 (KR)
(72) Inventor: SONG, Minho, 16677 Suwon-si, Gyeonggi-do (KR); MOON, Sunmin, 16677 Suwon-si, Gyeonggi-do (KR); CHANG, Jaewan, 16677 Suwon-si, Gyeonggi-do (KR)
(74) Representative: Kuhnen & Wacker Patent- und Rechtsanwaltsbüro PartG mbB

(57) **Abstract**

A semiconductor device includes a capacitor structure including a bottom electrode, a first dielectric layer on the bottom electrode, a second dielectric layer on the first dielectric layer, a third dielectric layer on the second dielectric layer, and a top electrode on the third dielectric layer, where each of the first dielectric layer and the third dielectric layer includes zirconium oxide, the second dielectric layer includes hafnium-zirconium oxide, and each of the first dielectric layer, the second dielectric layer, and the third dielectric layer includes a first crystal phase and a second crystal phase.

## Description

### BACKGROUND

The present disclosure relates to a semiconductor device including a capacitor structure.

Due to the small-sized, multifunctional, and/or low-cost characteristics, semiconductor devices are considered important elements in the electronic industry. The semiconductor devices may be classified into a semiconductor memory device for storing data, a semiconductor logic device for processing data, and a hybrid semiconductor device including both of memory and logic elements.

As integration densities of the semiconductor devices increase, it is necessary to realize a capacitor having sufficiently high capacitance in a limited area. The capacitance of the capacitor varies proportionally to the surface area of an electrode and the dielectric constant of a dielectric layer, and varies inversely with the equivalent oxide thickness of the dielectric layer.

### SUMMARY

One or more example embodiments provide a semiconductor device with improved capacitance characteristics.

One or more example embodiments provide a semiconductor device with a reduced leakage current.

Additional aspects will be set forth in part in the description which follows and, in part, will be apparent from the description, or may be learned by practice of the presented embodiments.

According to an aspect of an example embodiment, a semiconductor device may include a capacitor structure including a bottom electrode, a first dielectric layer on the bottom electrode, a second dielectric layer on the first dielectric layer, a third dielectric layer on the second dielectric layer, and a top electrode on the third dielectric layer, where each of the first dielectric layer and the third dielectric layer includes zirconium oxide, the second dielectric layer includes hafnium-zirconium oxide, and each of the first dielectric layer, the second dielectric layer, and the third dielectric layer includes a first crystal phase and a second crystal phase.

According to an aspect of an example embodiment, a semiconductor device may include a capacitor structure including a bottom electrode, a first dielectric layer on the bottom electrode, a second dielectric layer on the first dielectric layer, a third dielectric layer on the second dielectric layer, and a top electrode on the third dielectric layer, where each of the first dielectric layer and the third dielectric layer includes zirconium oxide, the second dielectric layer includes hafnium-zirconium oxide, and the capacitor structure is configured to reach a maximum capacitance when a voltage applied to the capacitor structure is within a range from -0.9 V to 0.9 V.

According to an aspect of an example embodiment, a semiconductor device may include a capacitor structure including a bottom electrode, a first dielectric layer on the bottom electrode, a second dielectric layer on the first dielectric layer, a third dielectric layer on the second dielectric layer, and a top electrode on the third dielectric layer, where each of the first dielectric layer and the third dielectric layer includes zirconium oxide, the second dielectric layer includes hafnium-zirconium oxide, and each of the first dielectric layer, the second dielectric layer, and the third dielectric layer includes an anti-ferroelectric region and a ferroelectric region.

According to an aspect of an example embodiment, a semiconductor device may include a substrate, a first conductive contact and a second conductive contact on the substrate, a first bottom electrode on the first conductive contact and a second bottom electrode on the second conductive contact, a first stack dielectric layer on the first bottom electrode and the second bottom electrode, the first stack dielectric layer including a first dielectric layer on each of the first bottom electrode and the second bottom electrode, a second dielectric layer on the first dielectric layer, and a third dielectric layer on the second dielectric layer, and a top electrode on the third dielectric layer, where each of the first dielectric layer and the third dielectric layer of the first stack dielectric layer includes zirconium oxide, and each of the first dielectric layer, the second dielectric layer, and the third dielectric layer of the first stack dielectric layer includes a first crystal phase and a second crystal phase.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a cross-sectional view illustrating a capacitor structure of a semiconductor device according to one or more example embodiments;
FIG. 2 is a plan view illustrating a capacitor structure of a semiconductor device according to one or more example embodiments;
FIG. 3 is a graph illustrating changes in capacitance of a capacitor with an applied voltage according to one or more example embodiments;
FIG. 4 is a plan view illustrating a semiconductor device at an intermediate forming stage according to one or more example embodiments;
FIG. 5 is a cross-sectional view corresponding to a line A-A' of FIG. 4 after the intermediate forming stage according to one or more example embodiments;
FIGS. 6 and 7 are cross-sectional views illustrating a semiconductor device according to one or more example embodiments;
FIGS. 8 to 10 are enlarged cross-sectional views corresponding to portions P1, P2, and P3 of FIG. 5 according to one or more example embodiments;
FIG. 11 is a plan view illustrating a semiconductor device according to one or more example embodiments;
FIGS. 12A and 12B are cross-sectional views corresponding to lines B-B' and C-C', respectively, of FIG. 11 according to one or more example embodiments;
FIG. 13 is a plan view illustrating a semiconductor device according to one or more example embodiments;
FIG. 14 is a perspective view illustrating a semiconductor device according to one or more example embodiments;
FIGS. 15A and 15B are cross-sectional views corresponding to lines D-D' and E-E', respectively, of FIG. 13 according to one or more example embodiments;
FIG. 16 is a plan view illustrating a semiconductor device according to one or more example embodiments; and
FIG. 17 is a perspective view illustrating a semiconductor device according to one or more example embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

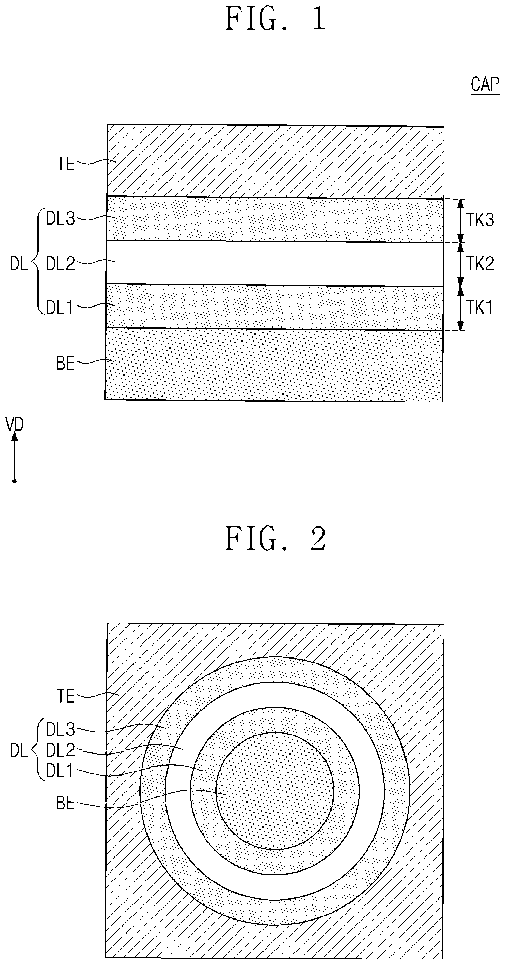

FIG. 1 is a cross-sectional view illustrating a capacitor structure of a semiconductor device according to one or more example embodiments.

Referring to FIG. 1, the semiconductor device may include a capacitor structure CAP. In some embodiments, the capacitor structure CAP may serve as a data storing element, and in this case, the semiconductor device according to some embodiments may be used as a semiconductor memory device. The capacitor structure CAP may include a bottom electrode BE, a stack dielectric layer DL, and a top electrode TE, which are sequentially provided in a vertical direction VD. The vertical direction VD may be a direction that is normal to an interface between the bottom electrode BE and the top electrode TE. The stack dielectric layer DL may be interposed between the bottom electrode BE and the top electrode TE.

Each of the bottom electrode BE and the top electrode TE may be formed of or include at least one conductive materials (e.g., doped silicon, doped silicon germanium, metallic materials, metal nitride materials, conductive oxide materials, and metal silicide materials). In some embodiments, each of the bottom electrode BE and the top electrode TE may be formed of or include at least one of VN, TiN, NbN, MoN, TaN, Ru, RuO₂, Pt, Ir, SrRuO₃, W, and WN. Each of the bottom electrode BE and the top electrode TE may be a single layer, which is made of a single material, or a composite layer including two or more materials.

The stack dielectric layer DL may include a first dielectric layer DL1, a second dielectric layer DL2, and a third dielectric layer DL3, which may be sequentially disposed on the bottom electrode BE. The first, second, and third dielectric layers DL1, DL2 and DL3 may be sequentially disposed in the vertical direction VD. In some embodiments, the first dielectric layer DL1 and the third dielectric layer DL3 may contact the bottom electrode BE and the top electrode TE, respectively, but example embodiments are not limited thereto. As an example, an additional layer may be further provided between the first dielectric layer DL1 and the bottom electrode BE or between the third dielectric layer DL3 and the top electrode TE. The second dielectric layer DL2 may be interposed between the first dielectric layer DL1 and the third dielectric layer DL3.

The first dielectric layer DL1 and the third dielectric layer DL3 may include the same material. In some embodiments, each of the first dielectric layer DL1 and the third dielectric layer DL3 may be formed of or include zirconium oxide (e.g., ZrO₂).

As an example, at least one of the first dielectric layer DL1 and the third dielectric layer DL3 may include aluminum-doped zirconium oxide. In the case where the aluminum-doped zirconium oxide is used, a leakage current of the capacitor structure CAP may be reduced. A concentration of the aluminum in the aluminum-doped zirconium oxide may be greater than 0 at% and may be smaller than or equal to 20at%, and when the aluminum concentration is within this range, the leakage current may be maximally reduced.

As another example, each of the first dielectric layer DL1 and the third dielectric layer may include aluminum-free zirconium oxide.

In some embodiments, each of the first dielectric layer DL1 and the third dielectric layer DL3 may contain at least one element of V, Ti, Nb, Mo, Ta, Ru, Pt, Sr, Ru, W, Si, B, Ge, Nb, Sc, Y, Fe, Os, Co, Rh, and Sn. The element may be present in the first dielectric layer DL1 and the third dielectric layer DL3, as a result of diffusion from an external structure (e.g., the bottom electrode BE or the top electrode BE) into the stack dielectric layer DL, but example embodiments are not limited thereto.

The second dielectric layer DL2 may include a material different from the first dielectric layer DL1 and the third dielectric layer DL3. For example, if the first dielectric layer DL1 and the third dielectric layer DL3 include zirconium oxide, the second dielectric layer DL2 may be formed of or include hafnium-zirconium oxide.

The hafnium-zirconium oxide may be represented as Hf₁₋ₓZrₓO₂. Here, the value of x may range from 0.1 to 0.7. The capacitance of the capacitor structure CAP may vary depending on voltages, which are applied to the bottom electrode BE and the top electrode TE, and the value of x. When the value of x is within the above range, the capacitance of the capacitor structure CAP may have the largest value (e.g., a maximum capacitance) within a low voltage range (e.g., between -0.9 V and 0.9 V). Thus, the capacitor structure CAP of the semiconductor device may be operated with a low voltage.

Each of the first, second, and third dielectric layers DL1, DL2 and DL3 may have two or more crystal phases. Each of the first, second, and third dielectric layers DL1, DL2 and DL3 may include first and second crystal phases, which are different from each other. The first crystal phase may be a crystal phase having an anti-ferroelectric property, and the second crystal phase may be a crystal phase having a ferroelectric property. For example, the first crystal phase may be a tetragonal crystal phase having the anti-ferroelectric property, and the second crystal phase may be an orthorhombic crystal phase having the ferroelectric property. Thus, each of the first, second, and third dielectric layers DL1, DL2 and DL3 may include an anti-ferroelectric region and a ferroelectric region.

The first crystal phase and the second crystal phase may be disposed in each of the first, second, and third dielectric layers DL1, DL2 and DL3 in various manners. As an example, a portion of the first crystal phase and a portion of the second crystal phase may be stacked on each other. As another example, another portion of the first crystal phase and another portion of the second crystal phase may be located at similar levels, and in this case, they may be observed on a single plane. However, example embodiments are not limited thereto, and the structure or configuration of the first and second crystal phases may be variously changed.

A polarization (P) of the stack dielectric layer DL may vary by a change in an electric field (E) produced by the bottom electrode BE and the top electrode TE, and such a change may be represented as a P-E hysteresis loop.

In a comparative example, the dielectric layer is composed of a ferroelectric region, without an anti-ferroelectric region, and in this case, the dielectric layer may have a non-vanishing polarization state (i.e., P≠0) when the electric field is zero (i.e., E=0). Thus, to alter the polarization direction of the dielectric layer or remove residual polarization, an electric field of an opposite direction should be applied to the dielectric layer. In the case where the dielectric layer exhibits this property, the capacitor structure may not be suitable for use as a data storing element in a volatile memory device.

In another comparative example, the dielectric layer is composed of an anti-ferroelectric region, without a ferroelectric region, and in this case, there may be no polarization when the electric field is weak, and it may have a low permittivity. In the case where the dielectric layer having these properties is used in the capacitor structure, the capacitor structure may not have a sufficient large capacitance.

According to some embodiments, the first crystal phase with the anti-ferroelectric region and the second crystal phase with the ferroelectric region may be provided in the stack dielectric layer DL in a mixed manner. Since the first and second crystal phases are mixed in the stack dielectric layer DL, the capacitor structure CAP may have a large capacitance and may be used as a data storing element in a volatile memory device. Each of the first, second, and third dielectric layers DL1, DL2 and DL3 may include the first and second crystal phases. In the case where each of the first to third dielectric layers DL1, DL2, and DL3 is formed to have a plurality of crystal phases, a fabrication process may be facilitated, as compared with the case where dielectric layers are formed to have single crystal phases different from each other. That is, according to some embodiments, the semiconductor device may be more easily fabricated.

When measured in the vertical direction VD, the first, second, and third dielectric layers DL1, DL2 and DL3 may have a first thickness TK1, a second thickness TK2, and a third thickness TK3, respectively. Each of the first and third thicknesses TK1 and TK3 may range from 5 Å to 40 Å. In the case where the first and third thicknesses TK1 and TK3 are smaller than 5 Å, a difficulty in a fabrication process and an amount of the leakage current may be increased. In the case where the first and third thicknesses TK1 and TK3 are larger than 40 Å, the capacitance of the capacitor structure CAP may be reduced. The second thickness TK2 may range from 5 Å to 30Å. In the case where the second thickness TK2 is smaller than 5 Å, a difficulty in the fabrication process and an amount of the leakage current may be increased. In the case where the second thickness TK2 is larger than 30 Å, the capacitance of the capacitor structure CAP may be reduced.

FIG. 2 is a plan view illustrating a capacitor structure of a semiconductor device according to one or more example embodiments.

Referring to FIG. 2, the bottom electrode BE may have a circular shape, in a plan view. The first, second, and third dielectric layers DL1, DL2 and DL3 may be provided to sequentially enclose the circular bottom electrode BE. In some embodiments, the first, second, and third dielectric layers DL1, DL2 and DL3 may be provided to conformally enclose the bottom electrode BE. The top electrode TE may enclose the third dielectric layer DL3. That is, the first dielectric layer DL1 may conformally enclose the bottom electrode BE, the second dielectric layer DL2 may conformally enclose the first dielectric layer DL1, the third dielectric layer DL3 may conformally enclose the second dielectric layer DL2, and the top electrode TE may enclose (or conformally enclose) the third dielectric layer DL3.

The bottom electrode BE may include a seam formed therein or may have a hollow doughnut shape, when viewed in a plan view. In the case where the bottom electrode BE is provided in the shape of the doughnut, the top electrode TE may further include a portion extended into the bottom electrode BE, and the stack dielectric layer DL may be interposed between the bottom electrode BE and the top electrode TE.

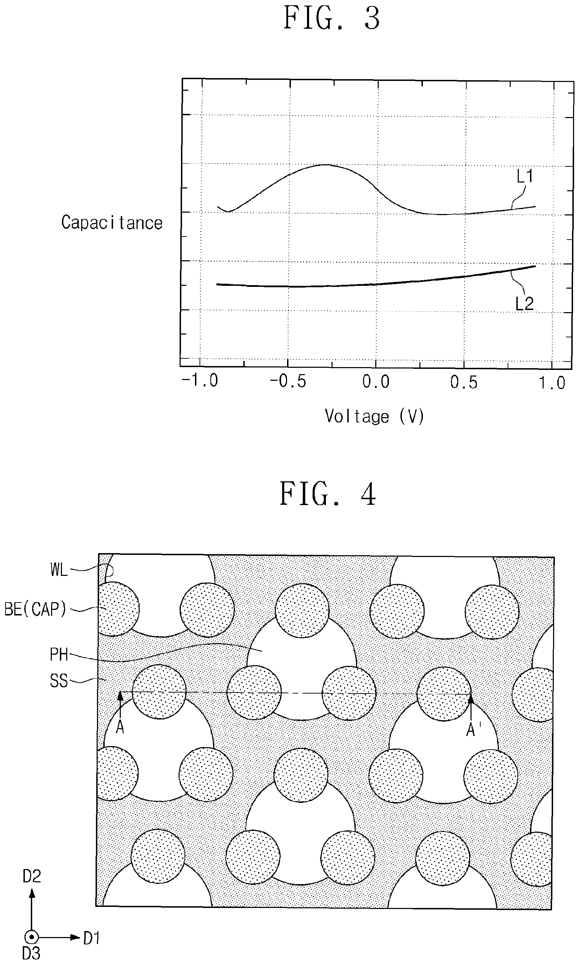

FIG. 3 is a graph illustrating changes in capacitance of a capacitor with an applied voltage according to one or more example embodiments.

Referring to FIG. 3, a capacitance of the capacitor structure CAP may vary by voltages applied to the bottom electrode BE and the top electrode TE. The voltage in the horizontal axis of FIG. 3 represents a potential difference between the bottom electrode BE and the top electrode TE. In FIG. 3, the curves L1 and L2 show the capacitance behavior of the capacitor structure CAP, which are respectively measured when the dielectric layers DL of two different chemical structures are used.

The curve L1 shows the capacitance of the capacitor structure CAP, in which the first, second, and third dielectric layers DL1, DL2 and DL3 include ZrO₂, Hf₁₋ₓZrₓO₂,
and ZrO₂, respectively. Here, the value of x ranges from 0.1 to 0.7. The curve L2 shows the capacitance of the capacitor structure CAP, in which the first, second, and third dielectric layers DL1, DL2 and DL3 include ZrO₂, Hf₁₋ₓZrₓO₂, and ZrO₂, respectively, and the value of x is smaller than 0.1 or is greater than 0.7.

Under the same voltage condition, the capacitance of the capacitor structure CAP may be greater in curve L1 than in curve L2. In addition, the capacitance of the capacitor structure CAP in curve L1 may have the largest value (e.g., a maximum value) within a voltage range from -0.9 V to 0.9 V. This shows that when the value of x in Hf₁₋ₓZrₓO₂ ranges from 0.1 to 0.7, the capacitor structure CAP has the highest (e.g., maximum) capacitance within a relatively low voltage range (e.g., from -0.9V to 0.9V). As a result, the capacitor structure CAP may be operated with a low voltage, and the electrical characteristics of the semiconductor device may be improved.

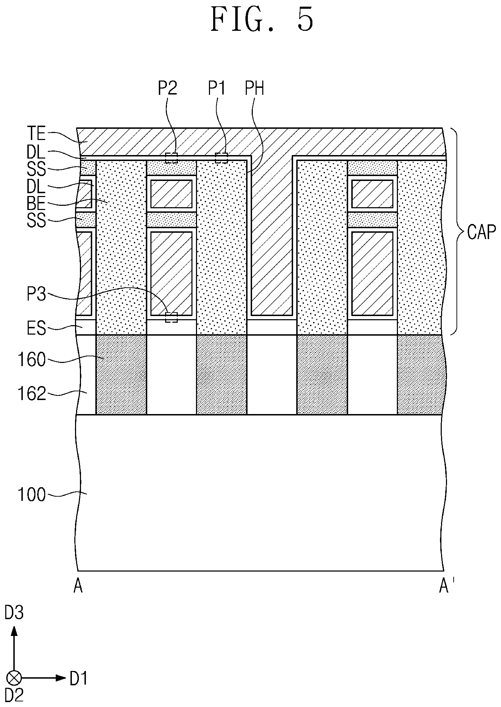

FIG. 4 is a plan view illustrating a semiconductor device at an intermediate forming stage according to one or more example embodiments. FIG. 5 is a cross-sectional view corresponding to a line A-A' of FIG. 4 after the intermediate forming stage according to one or more example embodiments.

Referring to FIGS. 4 and 5, a substrate 100 may be provided. The substrate 100 may be a semiconductor substrate. For example, the substrate 100 may be a silicon substrate, a germanium substrate, or a silicon-germanium substrate.

An interlayer insulating layer 162 may be disposed on the substrate 100. The interlayer insulating layer 162 may cover at least a portion of a top surface of the substrate 100. In some embodiments, the interlayer insulating layer 162 may be formed of or include at least one of silicon nitride, silicon oxide, and silicon oxynitride. In some embodiments, the interlayer insulating layer 162 may include an empty region (e.g., an air gap).

A conductive contact 160 may be disposed in the interlayer insulating layer 162. In some embodiments, a plurality of conductive contacts 160 may be provided to be spaced apart from each other in a first direction D1 and a second direction D2, which are parallel to a bottom surface of the substrate 100 and are non-parallel (e.g., orthogonal) to each other. The conductive contact 160 may be formed of or include at least one of doped semiconductor materials (e.g., poly silicon), metallic materials (e.g., Ti, Mo, W, Cu, Al, Ta, Ru, Ir, Co, Pt, Au, and Ag), metal nitride materials (e.g., nitride materials of Ti, Mo, W, Cu, Al, Ta, Ru, Ir, Co, Pt, Au, and Ag), and metal silicide materials (e.g., silicide materials of Ti, Mo, W, Cu, Al, Ta, Ru, Ir, Co, Pt, Au, and Ag). The conductive contact 160 may be electrically connected to an impurity region (e.g., a source/drain region) formed in the substrate 100.

An etch stop layer ES may be provided on the conductive contacts 160. The etch stop layer ES may be disposed on the interlayer insulating layer 162. The etch stop layer ES may be provided to cover the interlayer insulating layer 162 and expose the conductive contacts 160. The etch stop layer ES may include at least one of silicon oxide, SiCN, and SiBN. The capacitor structure CAP may correspond to the capacitor structure CAP of FIG. 1, may be provided on the etch stop layer ES and the conductive contacts 160, and may include the bottom electrode BE, the stack dielectric layer DL, and the top electrode TE.

The bottom electrode BE may be disposed on the conductive contact 160. The bottom electrode BE may penetrate the etch stop layer ES and may be electrically connected to the conductive contact 160. A lower portion of the bottom electrode BE may be enclosed by the etch stop layer ES.

A plurality of bottom electrodes BE may be provided to be spaced apart from each other in the first and second directions D1 and D2. For example, in a plan view, the bottom electrodes BE may be arranged in a honeycomb shape. Each of the bottom electrodes BE may be placed at the center of a hexagon defined by other six bottom electrodes BE.

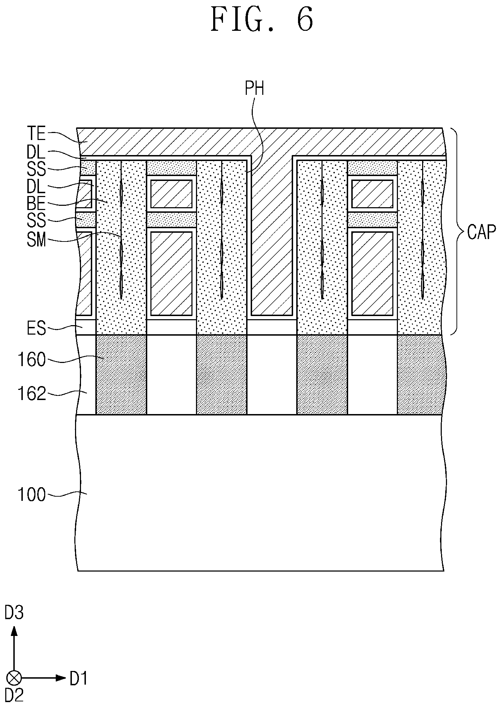

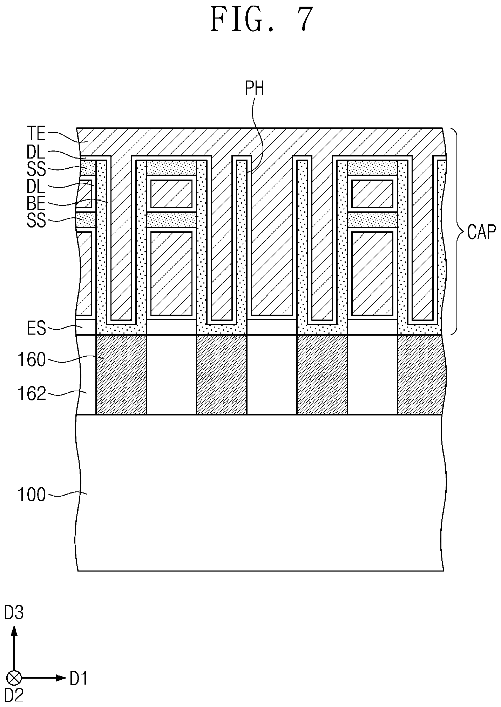

FIGS. 6 and 7 are cross-sectional views illustrating a semiconductor device according to one or more example embodiments.

Referring to FIGS. 5 to 7, the bottom electrode BE may have various shapes. For example, the bottom electrode BE may have a pillar shape, as shown in FIG. 5. The bottom electrode BE ma have a pillar shape with an internal seam SM, as shown in FIG. 6. The bottom electrode BE may have a hollow cylinder shape with one closed end (e.g., a cup shape), as shown in FIG. 7. However, the shape of the bottom electrode BE is not limited to these examples.

Referring back to FIGS. 4 and 5, the supporting layer SS may be provided on the substrate 100. The supporting layer SS may be provided between the bottom electrodes BE, which are adjacent to each other. The supporting layer SS may contact a side surface of the bottom electrode BE and may enclose the side surface of the bottom electrode BE. Accordingly, the supporting layer SS may mechanically support the bottom electrode BE.

A plurality of supporting layers SS may be provided to be spaced apart from each other a third direction D3 perpendicular to the bottom surface of the substrate 100. The supporting layers SS may have at least two different thicknesses, when measured in the third direction D3. A top surface of the uppermost one of the supporting layers SS may be located at a level that is different from or to the same as a top surface of the bottom electrode BE. In some embodiments, the supporting layer SS may be formed of or include at least one of silicon nitride, SiBN, and SiCN.

A penetration hole PH may be disposed between the bottom electrodes BE, which are adjacent to each other. As an example, each of the penetration holes PH may be disposed between three adjacent ones of the bottom electrodes BE to have a circular shape and expose a portion of a side surface of each of the three bottom electrodes BE. However, example embodiments are not limited thereto, and the penetration hole PH may have various shapes between the bottom electrodes BE. The penetration hole PH may be provided to penetrate the supporting layer SS. The penetration hole PH may expose the etch stop layer ES. In some embodiments, a plurality of penetration holes PH may be provided to be spaced apart from each other in the first and second directions D1 and D2.

The top electrode TE may be provided on the bottom electrode BE. The top electrode TE may cover the bottom electrode BE and the supporting layer SS. The top electrode TE may be provided to fill the penetration holes PH as well as spaces between the bottom electrodes BE, spaces between the supporting layers SS, and spaces between the lowermost one of the supporting layers SS and the etch stop layer ES.

The stack dielectric layer DL may be interposed between each of the bottom electrodes BE and the top electrode TE. The stack dielectric layer DL may extend into regions between the supporting layer SS and the top electrode TE and between the etch stop layer ES and the top electrode TE. The stack dielectric layer DL may conformally cover the supporting layer SS, the bottom electrodes BE, and the etch stop layer ES. The stack dielectric layer DL, along with the top electrode TE, may fill the penetration holes PH.

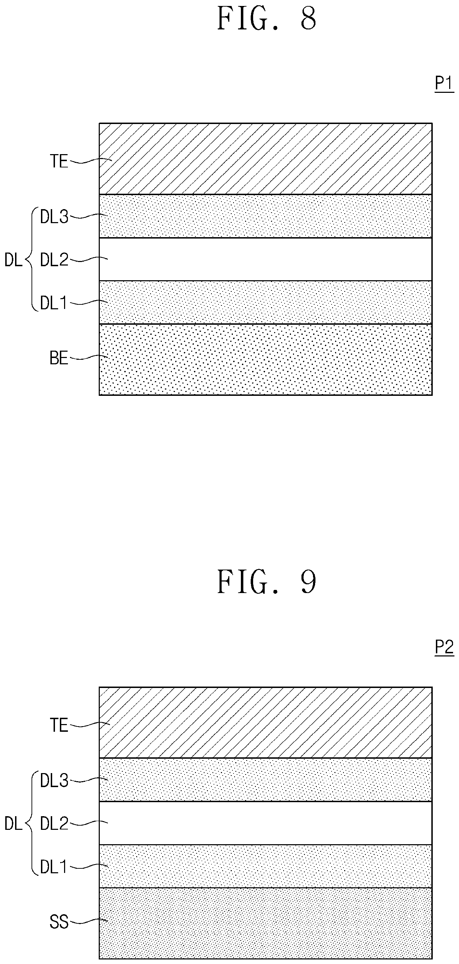

FIGS. 8 to 10 are enlarged cross-sectional views corresponding to portions P1, P2, and P3 of FIG. 5 according to one or more example embodiments.

Referring to FIGS. 8 to 10, the stack dielectric layer DL may include the first, second, and third dielectric layers DL1, DL2 and DL3. The first, second, and third dielectric layers DL1, DL2 and DL3 may correspond to the first, second, and third dielectric layers DL1, DL2 and DL3 of FIG. 1. As an example, the first, second, and third dielectric layers DL1, DL2 and DL3 may be interposed between the bottom electrode BE and the top electrode TE, as shown in FIG. 8, and may have structural and material characteristics that are similar to the first, second, and third dielectric layers DL1, DL2 and DL3 of FIG. 1.

The first, second, and third dielectric layers DL1, DL2 and DL3 may be further interposed between the supporting layer SS and the top electrode TE, as shown in FIG. 9. The first, second, and third dielectric layers DL1, DL2 and DL3 between the supporting layer SS and the top electrode TE may have structural and material characteristics that are similar to the first, second, and third dielectric layers DL1, DL2 and DL3 of FIG. 1, except that the supporting layer SS is provided in place of the bottom electrode BE.

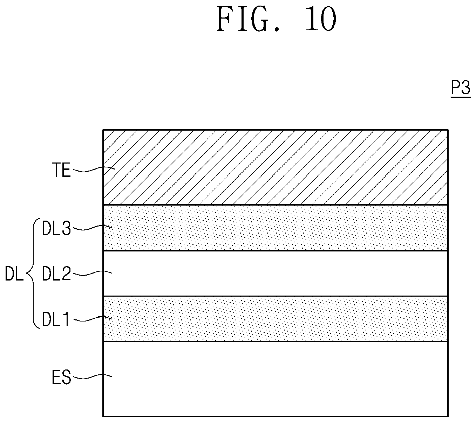

The first, second, and third dielectric layers DL1, DL2 and DL3 may be further interposed between the etch stop layer ES and the top electrode TE, as shown in FIG. 10. The first, second, and third dielectric layers DL1, DL2 and DL3 between the etch stop layer ES and the top electrode TE may have structural and material characteristics that are similar to the first, second, and third dielectric layers DL1, DL2 and DL3 of FIG. 1, except that the etch stop layer ES is provided in place of the bottom electrode BE.

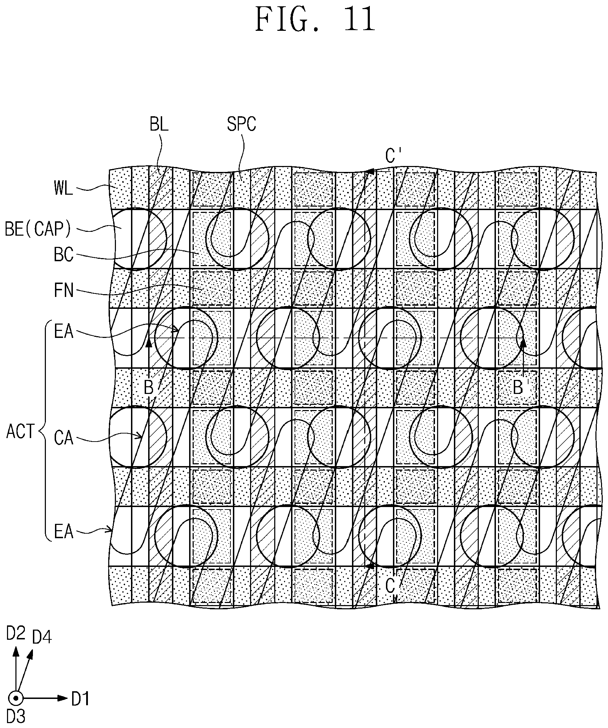

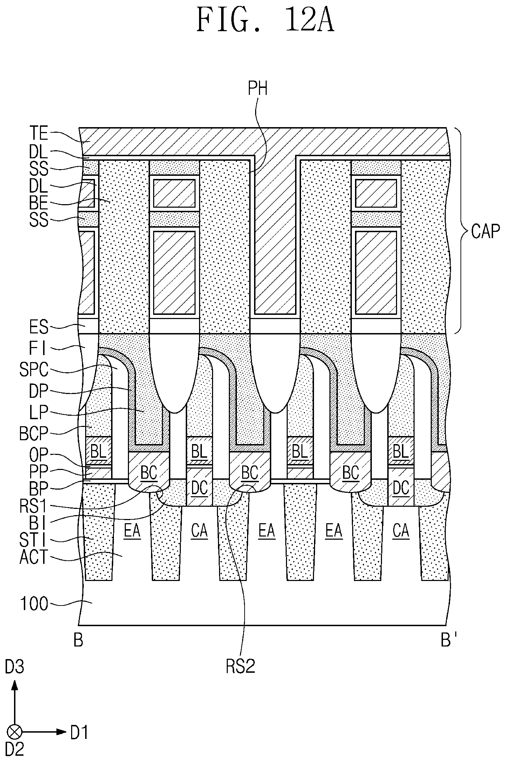

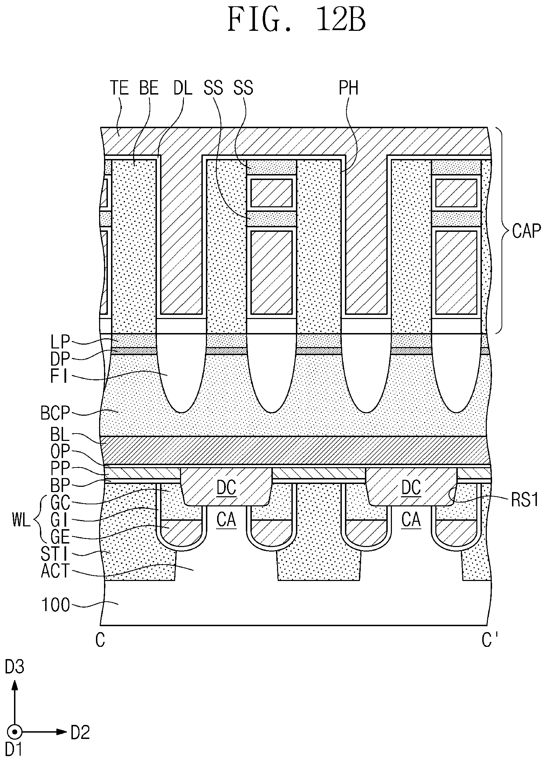

FIG. 11 is a plan view illustrating a semiconductor device according to one or more example embodiments. FIGS. 12A and 12B are cross-sectional views corresponding to lines B-B' and C-C', respectively, of FIG. 11 according to one or more example embodiments.

Referring to FIGS. 11, 12A, and 12B, the substrate 100 may be provided. The substrate 100 may correspond to the substrate 100 of FIG. 5.

A device isolation pattern STI may be disposed on the substrate 100. The device isolation pattern STI may define active patterns ACT on the substrate 100. Each of the active patterns ACT may have a shape protruding in the third direction D3. As an example, the device isolation pattern STI may be disposed in the substrate 100, and the active patterns ACT may be portions of the substrate 100 enclosed by the device isolation pattern STI. For ease of description, the term "substrate 100" may be used to refer to the remaining portion of the substrate 100, excluding the active patterns ACT, unless otherwise stated.

The active patterns ACT may be spaced apart from each other in the first and second directions D1 and D2. The active patterns ACT may be isolated bar-shaped patterns, which are spaced apart from each other and are elongated in a fourth direction D4. The fourth direction D4 may be parallel to the bottom surface of the substrate 100 and may not be parallel to the first and second directions D1 and D2.

Each of the active patterns ACT may include a pair of edge portions EA and a center portion CA. The paired edge portions EA may be two opposite ends of the active pattern ACT in the fourth direction D4. The center portion CA may be a portion of the active pattern ACT, which is interposed between the paired edge portions EA or between a pair of word lines WL to be described below. Each or at least one of the edge and center portions EA and CA may include an impurity region that is doped with impurities (e.g., n- or p-type impurities).

The device isolation pattern STI may include an insulating material. As an example, the device isolation pattern STI may be formed of or include at least one of silicon oxide or silicon nitride. The device isolation pattern STI may be a single layer, which is made of one of the above materials, or a composite layer, which is made of at least two of the above materials.

A word line WL may be disposed to cross the active patterns ACT. As an example, the word line WL may cross the active patterns ACT and the device isolation pattern STI in the first direction D1. In some embodiments, a plurality of word lines WL may be provided. The word lines WL may be spaced apart from each other in the second direction D2. In some embodiments, a pair of the word lines WL, which are adjacent to each other in the second direction D2, may be provided to cross the active pattern ACT.

As an example, each of the word lines WL may include a gate electrode GE, a gate insulating pattern GI, and a gate capping pattern GC. The gate electrode GE may be provided to cross the active patterns ACT and the device isolation pattern STI in the first direction D1. The gate insulating pattern GI may be interposed between the gate electrode GE and the active patterns ACT. The gate capping pattern GC may cover a top surface of the gate electrode GE.

A buffer pattern BP may be disposed on the substrate 100. The buffer pattern BP may cover the active patterns ACT, the device isolation pattern STI, and the word lines WL. In some embodiments, the buffer pattern BP may be formed of or include at least one of silicon oxide, silicon nitride, and silicon oxynitride. The buffer pattern BP may be a single layer, which is made of a single material, or a composite layer including two or more materials.

A bit line node contact DC may be provided on each of the active patterns ACT, and in some embodiments, a plurality of bit line node contacts DC may be provided. Each of the bit line node contacts DC may be connected to a corresponding one of the center portions CA of the active patterns ACT. The bit line node contacts DC may be spaced apart from each other in the first and second directions D1 and D2. The bit line node contacts DC may be interposed between the active patterns ACT and bit lines BL to be described below. Each of the bit line node contacts DC may connect a corresponding one of the bit lines BL to the center portion CA of a corresponding one of the active patterns ACT. In some embodiments, the bit line node contact DC may be formed of or include doped polysilicon.

The bit line node contacts DC may be disposed in first recess regions RS1, respectively. The first recess regions RS1 may be provided in upper portions of the active patterns ACT and an upper portion of the device isolation pattern STI adjacent thereto. The first recess regions RS1 may be spaced apart from each other in the first and second directions D1 and D2.

A gapfill insulating pattern BI may be provided to fill each of the first recess regions RS1. The gapfill insulating pattern BI may fill an inner space of the first recess region RS1. In some embodiments, the gapfill insulating pattern BI may cover an inner surface of the first recess region RS1 as well as at least a portion of a side surface of the bit line node contact DC (e.g., in the first recess region RS1). The gapfill insulating pattern BI may be formed of or include at least one of silicon oxide, silicon nitride, or combinations thereof. The gapfill insulating pattern BI may be a single layer, which is made of a single material, or a composite layer including two or more materials.

The bit line BL may be provided on the bit line node contact DC. The bit line BL may be disposed on the bit line node contacts DC, which are linearly arranged in the second direction D2. In some embodiments, a plurality of bit lines BL may be provided. The bit lines BL may be spaced apart from each other in the first direction D1. The bit line BL may include a metallic material. As an example, the bit line BL may be formed of or include at least one metallic material (e.g., Ti, Mo, W, Cu, Al, Ta, Ru, Ir, Co, Pt, Au, and Ag).

A polysilicon pattern PP may be interposed between the bit line BL and the buffer pattern BP. A top surface of the polysilicon pattern PP may be located at substantially the same height as a top surface of the bit line node contact DC. The polysilicon pattern PP may include a doped polysilicon.

An ohmic pattern OP may be interposed between the bit line BL and the bit line node contact DC and between the bit line BL and the polysilicon pattern PP. The ohmic pattern OP may be formed of or include at least one metal silicide material (e.g., silicide materials of Ti, Mo, W, Cu, Al, Ta, Ru, Ir, Co, Pt, Au, and Ag). In some embodiments, a barrier pattern may be further interposed between the bit line BL and the bit line node contact DC and between the bit line BL and the polysilicon pattern PP. The barrier pattern may be formed of or include at least one conductive metal nitride material (e.g., nitride materials of Ti, Mo, W, Cu, Al, Ta, Ru, Ir, Co, Pt, Au, and Ag).

A bit line capping pattern BCP may be provided on the bit line BL. In some embodiments, the bit line capping patterns BCP may be provided on the top surfaces of the bit lines BL, respectively. The bit line capping patterns BCP may be extend along the bit lines BL or in the second direction D2 and may be spaced apart from each other in the first direction D1. Each of the bit line capping patterns BCP may be vertically above a corresponding one of the bit lines BL. The bit line capping pattern BCP may be composed of a single layer or a plurality of layers. As an example, the bit line capping pattern BCP may include first, second, and third capping patterns, which are sequentially stacked. In some embodiments, each of the first to third capping patterns may include silicon nitride. As another example, the bit line capping pattern BCP may further include additional capping patterns (e.g., fourth and fifth capping patterns).

A bit line spacer SPC may be provided on a side surface of the bit line BL and a side surface of the bit line capping pattern BCP. The bit line spacer SPC may cover the side surface of the bit line BL and the side surface of the bit line capping pattern BCP. The bit line spacer SPC may be provided on the side surface of the bit line BL and may be extended in the second direction D2.

Each of the bit line spacers SPC may include a plurality of sub-spacers. In some embodiments, each of the bit line spacers SPC may include three or more sub-spacers, which are sequentially provided on the side surface of the bit line BL. Each of the sub-spacers may independently include at least one of silicon nitride, silicon oxide, or silicon oxynitride. As another example, at least one of the sub-spacers may include an air gap separating others of the sub-spacers from each other.

A storage node contact BC may be provided between adjacent bit lines BL. In some embodiments, a plurality of storage node contacts BC may be provided to be spaced apart from each other in the first and second directions D1 and D2. The storage node contact BC may fill a second recess region RS2, which is formed on the edge portion EA of the active pattern ACT. The storage node contact BC may be electrically connected to the edge portion EA. The storage node contact BC may include a conductive material. As an example, the storage node contact BC may be formed of or include at least one of doped polysilicon and metallic materials (e.g., Ti, Mo, W, Cu, Al, Ta, Ru, Ir, Co, Pt, Au, and Ag).

On the word lines WL, fence patterns FN may separate the storage node contacts BC from each other in the second direction D2. In some embodiments, the fence patterns FN may be spaced apart from each other in the second direction D2 with the storage node contacts BC interposed therebetween. In some embodiments, the fence patterns FN may be formed of or include silicon nitride.

A diffusion barrier layer DP may conformally cover the storage node contact BC and the bit line spacer SPC. The diffusion barrier layer DP may be formed of or include a conductive metal nitride material (e.g., containing at least one of Ti, Mo, W, Cu, Al, Ta, Ru, Ir, Co, Pt, Au, or Ag). A metal silicide layer may be further interposed between the diffusion barrier layer DP and the storage node contact BC.

A landing pad LP may be provided on the storage node contact BC. In some embodiments, a plurality of landing pads LP may be provided and may be spaced apart from each other in the first and second directions D1 and D2. Each of the landing pads LP may be connected to a corresponding one of the storage node contacts BC. The landing pad LP may cover a top surface of the bit line capping pattern BCP. In some embodiments, a lower portion of the landing pad LP may be vertically above the storage node contact BC, and an upper portion of the landing pad LP may be offset from the lower portion in the second direction D2 or an opposite direction thereof. The landing pad LP may be formed of or include at least one metallic material (e.g., Ti, Mo, W, Cu, Al, Ta, Ru, Ir, Co, Pt, Au, and Ag).

A filler pattern FI may be provided to enclose the landing pad LP. The filler pattern FI may be interposed between the landing pads LP, which are adjacent to each other. In a plan view, the filler pattern FI may be provided in a mesh shape with holes, and in this case, the landing pads LP may be provided in the holes to penetrate the filler pattern FI. The filler pattern FI may be formed of or include at least one of silicon nitride, silicon oxide, and silicon oxynitride. Alternatively, the filler pattern FI may include an empty space with an air layer (e.g., an air gap).

The capacitor structure CAP, the etch stop layer ES, and the supporting layer SS may be provided on the conductive contacts 160. The capacitor structure CAP, the etch stop layer ES, and the supporting layer SS may correspond to the capacitor structure CAP, the etch stop layer ES, and the supporting layer SS of FIGS. 4 to 10. Thus, the capacitor structure CAP, the etch stop layer ES, and the supporting layer SS of FIGS. 11, 12A, and 12B may have substantially the same or similar features as the capacitor structure CAP, the etch stop layer ES, and the supporting layer SS of FIGS. 4 to 10.

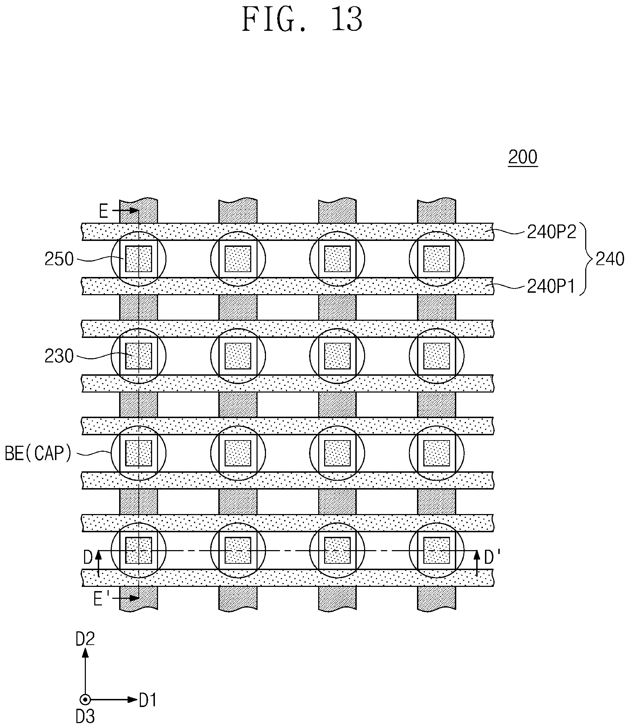

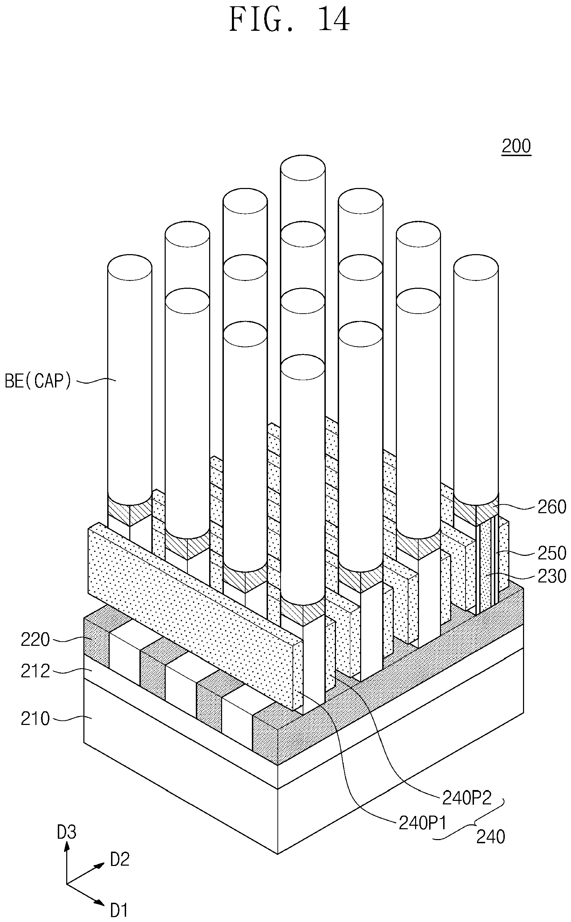

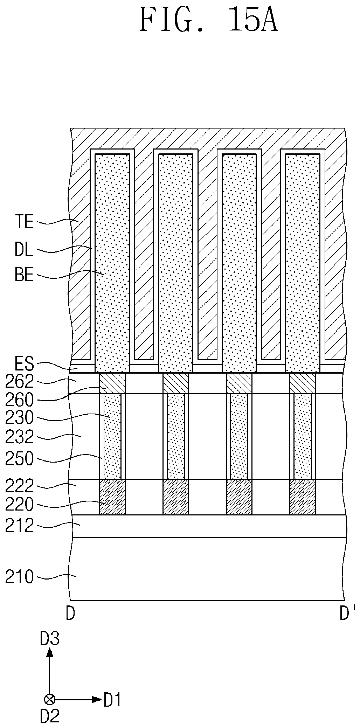

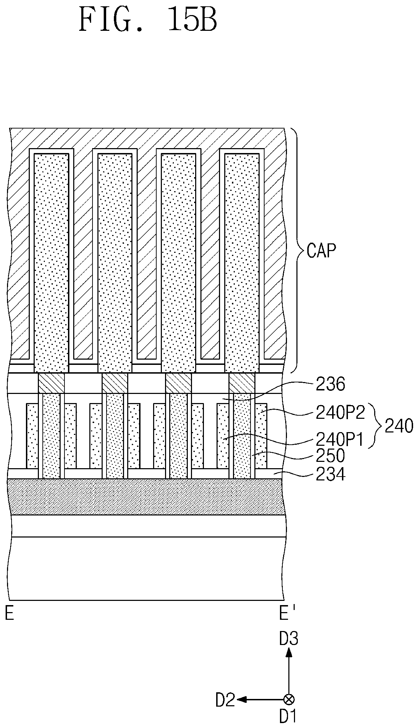

FIG. 13 is a plan view illustrating a semiconductor device according to one or more example embodiments. FIG. 14 is a perspective view illustrating a semiconductor device of FIG. 13 according to one or more example embodiments. FIGS. 15A and 15B are cross-sectional views corresponding to lines D-D' and E-E', respectively, of FIG. 13 according to one or more example embodiments.

Referring to FIGS. 13 to 15B, a semiconductor device 200 may include a substrate 210, a plurality of first conductive lines 220, a channel layer 230, a gate electrode 240, a gate insulating layer 250, and a capacitor structure CAP. The semiconductor device 200 may be a memory device including a vertical channel transistor (VCT). The VCT may refer to a transistor structure, in which the channel layer 230 extends from the substrate 210 in a vertical direction or a channel length is defined in the vertical direction.

A lower insulating layer 212 may be disposed on the substrate 210, and the first conductive lines 220, which are spaced apart from each other in the first direction D1 and extend in the second direction D2, may be disposed on the lower insulating layer 212. A plurality of first insulating patterns 222 may be disposed on the lower insulating layer 212 to fill empty spaces between the first conductive lines 220. The first insulating patterns 222 may extend in the second direction D2, and the first insulating patterns 222 may have top surfaces that are located at the same level as top surfaces of the first conductive lines 220. The first conductive lines 220 may serve as the bit lines of the semiconductor device 200.

In some embodiments, the first conductive lines 220 may be formed of or include at least one of doped polysilicon, metallic materials, conductive metal nitride materials, conductive metal silicide materials, conductive metal oxide materials, and combinations thereof. For example, the first conductive lines 220 may be formed of or include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, and combinations thereof, but example embodiments are not limited thereto. The first conductive lines 220 may include one or more layers, each of which is formed of at least one of the afore-described materials. In some embodiments, the first conductive lines 220 may be formed of or include at least one of two-dimensional semiconductor materials (e.g., graphene, carbon nanotube, and combinations thereof).

The channel layer 230 may be placed on the first conductive lines 220 to be spaced apart from each other in the first and second directions D1 and D2 and form a matrix-shaped arrangement. The channel layer 230 may have a first width in the first direction D1 and a first height in the third direction D3, and the first height may be larger than the first width. For example, the first height may be about 2 to 10 times the first width, but example embodiments are not limited thereto. A bottom portion of the channel layer 230 may be used as a first source/drain region, an upper portion of the channel layer 230 may be used as a second source/drain region, and a portion of the channel layer 230 between the first and second source/drain region may be used as a channel region.

In some embodiments, the channel layer 230 may be formed of or include at least one oxide semiconductor material (e.g., InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, and combinations thereof). The channel layer 230 may have a single-layered or multi-layered structure of the oxide semiconductor material. In some embodiments, the channel layer 230 may have a band gap energy that is greater than that of silicon. For example, the channel layer 230 may have a band gap energy of about 1.5 eV to 5.6 eV. In some embodiments, when the channel layer 230 has a band gap energy of about 2.0 eV to 4.0 eV, the channel layer 230 may exhibit an optimized channel performance. In some embodiments, the channel layer 230 may have a polycrystalline or amorphous structure, but example embodiments are not limited thereto. In some embodiments, the channel layer 230 may include a two-dimensional semiconductor material (e.g., graphene, carbon nanotube, or combinations thereof).

The gate electrode 240 may extend in the first direction D1, on opposite side surfaces of the channel layer 230. For example, the gate electrode 240 may include a first sub-gate electrode 240P1, which is provided to face a first side surface of the channel layer 230, and a second sub-gate electrode 240P2, which is provided to face a second side surface of the channel layer 230 opposite to the first side surface. Since one channel layer 230 is disposed between the first sub-gate electrode 240P1 and the second sub-gate electrode 240P2, the semiconductor device 200 may have a dual gate transistor structure. However, example embodiments are not limited thereto, and the semiconductor device 200 may have a single gate transistor structure, which has the first sub-gate electrode 240P1 facing the first side surface of the channel layer 230, without the second sub-gate electrode 240P2.

The gate electrode 240 may be formed of or include at least one of doped polysilicon, metallic materials, conductive metal nitride materials, conductive metal silicide materials, conductive metal oxide materials, and combinations thereof. For example, the gate electrode 240 may be formed of or include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, and combinations thereof, but example embodiments are not limited thereto.

The gate insulating layer 250 may be interposed between the channel layer 230 and the gate electrode 240 and may enclose the side surface of the channel layer 230. For example, as shown in FIG. 13, the entire side surface of the channel layer 230 may be enclosed by the gate insulating layer 250, and a portion of the side surface of the gate electrode 240 may contact the gate insulating layer 250. In some embodiments, the gate insulating layer 250 may extend in an extension direction (i.e., the first direction D1) of the gate electrode 240, and only two opposite side surfaces of the channel layer 230 facing the gate electrode 240 may contact the gate insulating layer 250.

In some embodiments, the gate insulating layer 250 may be formed of or include at least one of silicon oxide, silicon oxynitride, high-k dielectric materials having dielectric constants higher than silicon oxide, and combinations thereof. The high-k dielectric materials may include metal oxide materials or metal oxynitride materials. For example, the high-k dielectric material for the gate insulating layer 250 may include HfO₂, HfSiO, HfSiON, HfTaO, HfTiO, HfZrO, ZrO₂, Al₂O₃, and combinations thereof, but example embodiments are not limited thereto.

A plurality of second insulating patterns 232 may be provided on the first insulating patterns 222 to extend in the second direction D2, and the channel layer 230 may be disposed between two adjacent ones of the second insulating patterns 232. In some embodiments, a first filling layer 234 and a second filling layer 236 may be disposed in a space between two adjacent ones of the channel layers 230. The first filling layer 234 may be disposed in a bottom portion of the space between the two adjacent ones of the channel layers 230, and the second filling layer 236 may be disposed on the first filling layer 234 to fill a remaining portion of the space between the two adjacent ones of the channel layers 230. A top surface of the second filling layer 236 may be placed at the same a level as a top surface of the channel layer 230, and the second filling layer 236 may cover a top surface of the gate electrode 240. Alternatively, the second insulating patterns 232 and the first insulating patterns 222 may be formed to have a continuous structure without an observable interface therebetween or the second filling layer 236 and the first filling layer 234 may be formed to have a continuous structure without an observable interface therebetween.

A capacitor contact 260 may be disposed on the channel layer 230. In some embodiments, the capacitor contacts 260 may be vertically above the channel layers 230 and may be spaced apart from each other in the first and second directions D1 and D2 to form a matrix-shaped arrangement. The capacitor contact 260 may be formed of or include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, and combinations thereof, but example embodiments are not limited thereto. An upper insulating layer 262 may be provided on the second insulating patterns 232 and the second filling layer 236 to enclose a side surface of the capacitor contact 260.

The etch stop layer ES may be disposed on the upper insulating layer 262, and the capacitor structure CAP may be disposed on the etch stop layer ES. The capacitor structure CAP may correspond to the capacitor structure CAP of FIG. 1. For example, the capacitor structure CAP may include the bottom electrode BE, the stack dielectric layer DL, and the top electrode TE, and the stack dielectric layer DL may include the first to third dielectric layers DL1, DL2, and DL3.

The bottom electrode BE may be provided to penetrate the etch stop layer ES and may be electrically connected to a top surface of the capacitor contact 260. The bottom electrode BE may have a pillar-shaped structure extending in the third direction D3, but example embodiments are not limited thereto. In some embodiments, the bottom electrode BE may be disposed to be vertically above the capacitor contact 260 and may be spaced apart from each other in the first and second directions D1 and D2 to form a matrix-shaped arrangement. Alternatively, a landing pad may be further disposed between the capacitor contact 260 and the bottom electrode BE, and the bottom electrodes BE may be arranged in a hexagonal shape.

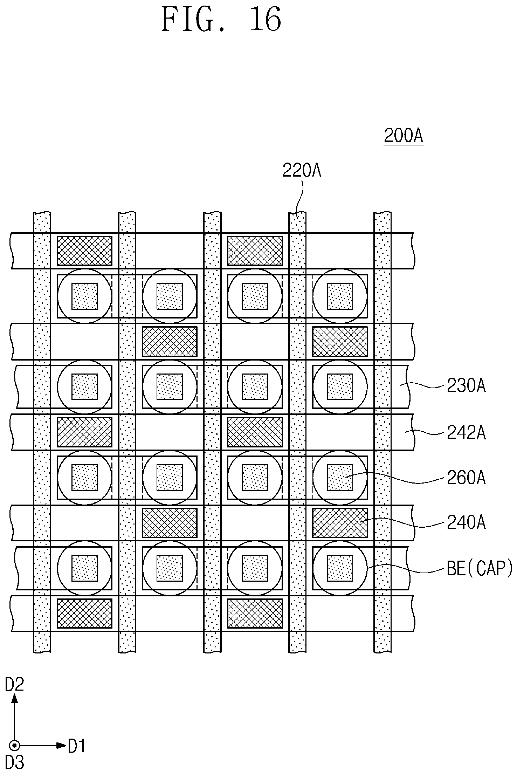

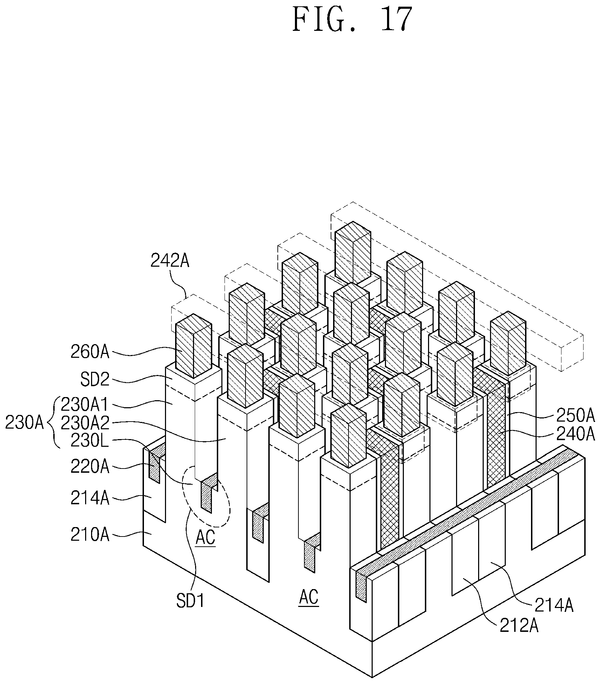

FIG. 16 is a plan view illustrating a semiconductor device according to one or more example embodiments. FIG. 17 is a perspective view illustrating a semiconductor device of FIG. 16 according to one or more example embodiments.

Referring to FIGS. 16 and 17, a semiconductor device 200A may include a substrate 210A, a plurality of first conductive lines 220A, a channel structure 230A, a contact gate electrode 240A, a plurality of second conductive lines 242A, and a capacitor structure CAP. In some embodiments, the semiconductor device 200A may be a memory device including a VCT.

A plurality of active regions AC may be defined in the substrate 210A by a first device isolation layer 212A and a second device isolation layer 214A. The channel structure 230A may be formed in each of the active regions AC and may include a first active pillar 230A1 and a second active pillar 230A2, which extend in a vertical direction, and a connecting portion 230L, which is connected to bottom portions of the first and second active pillars 230A1 and 230A2. A first source/drain region SD1 may be disposed in the connecting portion 230L, and a second source/drain region SD2 may be disposed in an upper portion of each of the first and second active pillars 230A1 and 230A2. The first and second active pillars 230A1 and 230A2 may be used as parts of independent unit memory cells, respectively.

Each of the first conductive lines 220A may extend to cross the active regions AC in, for example, the second direction D2. One of the first conductive lines 220A may be disposed on the connecting portion 230L and between the first and second active pillars 230A1 and 230A2, and in particular, on the first source/drain region SD1. Another one of the first conductive lines 220A, which is adjacent to the one of the first conductive lines 220A, may be disposed between two of the channel structure 230A. One of the first conductive lines 220A may serve as a common bit line, which is shared by two unit memory cells that are composed of the first and second active pillars 230A1 and 230A2 placed at both sides of the same.

One contact gate electrode 240A may be disposed between two channel structures 230A, which are adjacent to each other in the second direction D2. For example, the contact gate electrode 240A may be disposed between the first active pillar 230A1, which is included in one channel structure 230A, and the second active pillar 230A2, which is included in another channel structure 230A adjacent thereto, and one of the contact gate electrodes 240A may be shared by the first and second active pillars 230A1 and 230A2 which are disposed at both sides of the same. A gate insulating layer 250A may be disposed between the contact gate electrode 240A and the first active pillar 230A1, and between the contact gate electrode 240A and the second active pillar 230A2. The second conductive lines 242A may be provided on the top surfaces of the contact gate electrodes 240A and may extend in the first direction D1. The second conductive lines 242A may serve as the word lines in the semiconductor device 200A.

The capacitor contact 260A may be disposed on the channel structure 230A. The capacitor contact 260A may be disposed on the second source/drain region SD2, and the capacitor structure CAP may be disposed on the capacitor contact 260A. The capacitor structure CAP may correspond to the capacitor structure CAP of FIG. 1. For example, the capacitor structure CAP may include the bottom electrode BE, the stack dielectric layer DL, and the top electrode TE, and here, the stack dielectric layer DL may include the first to third dielectric layers DL1, DL2, and DL3.

According to some embodiments, a first crystal phase having an anti-ferroelectric region and a second crystal phase having a ferroelectric region may be provided in a dielectric layer in a mixed manner to improve capacitance characteristics of the capacitor structure. In addition, the dielectric layer may be doped with aluminum to reduce a leakage current. Thus, electrical characteristics of the semiconductor device may be improved.

Furthermore, the dielectric layer may be a stack dielectric layer composed of a plurality of dielectric layers, each of which has first and second crystal phases, and this may facilitate a process of fabricating a semiconductor device.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the spirit and scope of the following claims.

## Claims

1. A capacitor structure comprising:
a bottom electrode;
a first dielectric layer on the bottom electrode;
a second dielectric layer on the first dielectric layer;
a third dielectric layer on the second dielectric layer; and
a top electrode on the third dielectric layer,
wherein each of the first dielectric layer and the third dielectric layer comprises zirconium oxide,
wherein the second dielectric layer comprises hafnium-zirconium oxide, and
wherein each of the first dielectric layer, the second dielectric layer, and the third dielectric layer comprises a first crystal phase and a second crystal phase.

2. The capacitor structure of claim 1, wherein the first crystal phase of each of the first dielectric layer, the second dielectric layer, and the third dielectric layer has an anti-ferroelectric property, and
wherein the second crystal phase of each of the first dielectric layer, the second dielectric layer, and the third dielectric layer has a ferroelectric property.

3. The capacitor structure of claim 1 or 2, wherein the first crystal phase each of the first dielectric layer, the second dielectric layer, and the third dielectric layer is a tetragonal crystal phase, and
wherein the second crystal phase each of the first dielectric layer, the second dielectric layer, and the third dielectric layer is an orthorhombic crystal phase.

4. The capacitor structure of any one of claims 1 to 3, wherein the hafnium-zirconium oxide of the second dielectric layer is Hf₁₋ₓZrₓO₂, and
wherein x ranges from 0.1 to 0.7.

5. The capacitor structure of any one of claims 1 to 4, wherein at least one of the first dielectric layer, the second dielectric layer, and the third dielectric layer comprises aluminum-doped zirconium oxide.

6. The capacitor structure of claim 5, wherein an aluminum concentration in the aluminum-doped zirconium oxide is greater than 0 at% and is lower than or equal to 20 at%.

7. The capacitor structure of any one of claims 1 to 6, wherein the capacitor structure is configured to reach a maximum capacitance when a voltage applied to the capacitor structure is within a range from -0.9 V to 0.9 V.

8. The capacitor structure of any one of claims 1 to 7, wherein a thickness of each of the first dielectric layer, the second dielectric layer, and the third dielectric layers ranges from 5 Å to 40 Å.

9. The capacitor structure of any one of claims 1 to 8, wherein a thickness of the second dielectric layer ranges from 5 Å to 30 Å.

10. The capacitor structure of any one of claims 1 to 9, wherein the first dielectric layer contacts the bottom electrode, and
wherein the third dielectric layer contacts the top electrode.

11. The capacitor structure of any one of claims 1 to 10, wherein, in a plan view, the first dielectric layer, the second dielectric layer, and the third dielectric layer sequentially enclose the bottom electrode.

12. The capacitor structure of any one of claims 1 to 11, wherein the bottom electrode has a pillar shape or a cylinder shape.

13. A semiconductor device comprising:
a substrate;
a first conductive contact and a second conductive contact on the substrate;
a capacitor structure according to any one of claims 1 to 12 on the first conductive contact and on the second conductive contact, wherein:
the bottom electrode of the capacitor structure is a first bottom electrode on the first conductive contact and the capacitor structure comprises a second bottom electrode on the second conductive contact; the capacitor structure comprises a first stack dielectric layer on the first bottom electrode and the second bottom electrode, the first stack dielectric layer comprising:
the first dielectric layer on each of the first bottom electrode and the second bottom electrode;
the second dielectric layer on the first dielectric layer; and
the third dielectric layer on the second dielectric layer; and
the capacitor structure comprising a top electrode on the third dielectric layer.

14. The semiconductor device of claim 13, wherein each of the first bottom electrode and the second bottom electrode has a pillar shape or a cylinder shape.

15. The semiconductor device of claim 13 or 14, wherein the first crystal phase of each of the first dielectric layer, the second dielectric layer, and the third dielectric layer of the first stack dielectric layer is a tetragonal crystal phase, and
wherein the second crystal phase of each of the first dielectric layer, the second dielectric layer, and the third dielectric layer of the first stack dielectric layer is an orthorhombic crystal phase.
